# EUROPÄISCHE PATENTSCHRIFT

(11) **EP 0 727 726 B1**
(45) Veröffentlichungstag und Bekanntmachung des Hinweises auf die Patenterteilung: **26.04.2000**
(21) Anmeldenummer: 96101353.9
(22) Anmeldetag: 31.01.1996
(51) Int. Cl.: G05F 3/22, H03F 1/34, H01L 27/06

(54) **Integrierbare Schaltungsanordnung zur Arbeitsstromstabilisierung eines Transistors durch Gegenkopplung, insbesondere geeignet für batteriebetriebene Geräte**
Integrable circuit for load current stabilizing of a transistor by inverse feedback, especially appropriate for battery-powered devices
Circuit intégrable pour la stabilisation de courant de travail d'un transistor par contre-réaction, en particulier approprié pour des appareils à piles

(30) Priorität: 16.02.1995 DE 19505269
(43) Veröffentlichungstag der Anmeldung: 21.08.1996
(73) Patentinhaber: SIEMENS AKTIENGESELLSCHAFT, 80333 München (DE)
(72) Erfinder: Deckers, Margarete, Dipl.-Phys., D-81737 München (DE); Musiol, Lothar, Dipl.-Ing., D-81735 München (DE); Schöpf, Klaus-Jürgen, Dipl.-Ing., D-85737 Ismaning (DE)

(56) Entgegenhaltungen:
- EP-A- 0 509 285
- DE-B- 2 051 536
- DE-C- 2 705 276

## Beschreibung

Die Erfindung bezieht sich auf eine Schaltungsanordnung zur Arbeitsstromstabilisierung eines Transistors durch Gegenkopplung.

Solche Schaltungsanordnungen sind beispielsweise in E.Böhmer, Elemente der angewandten Elektronik, 9. Auflage, Vieweg-Verlag, Braunschweig, Deutschland, 1994 beschrieben und als Parallelgegenkopplung bzw. Reihengegenkopplung bekannt.

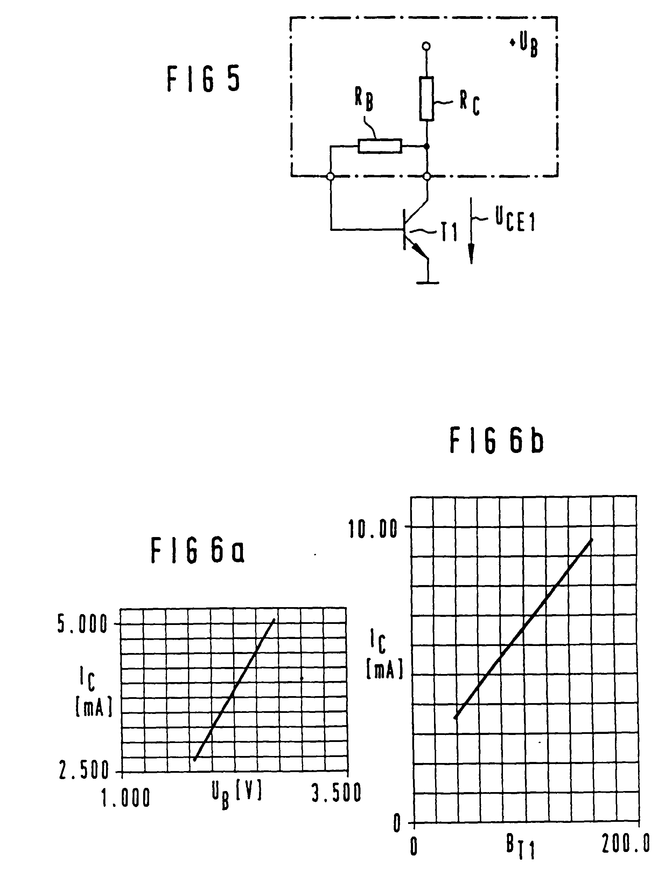

Die Parallelgegenkopplung ist in Figur 5 in ihrer prinzipiellen Art gezeigt. Parallel zur Kollektor-Basis-Strecke des zu regelnden Transistors T1 ist ein Widerstand R_{B} angeschlossen. Eine beispielsweise temperaturbedingte Erhöhung des Arbeitstromes I_{C1} bewirkt eine Absenkung der Kollektor-Emitter-Spannung U_{CE1} und gleichzeitig eine Absenkung des Basisstromes I_{B1}, was im Sinne einer Gegensteuerung wirkt.

Bei der Reihengegenkopplung ist in der Emitterzuleitung ein Widerstand angeschlossen. Das Basispotential ist über einen Spannungsteiler eingestellt. Im Falle einer temperaturbedingten Erhöhung des Arbeitsstromes wird das Emitterpotential angehoben, wodurch die Basis-Emitter-Spannung und damit wiederum der Basisstrom abgesenkt wird.

Neben Temperaturschwankungen können auch Schwankungen der Versorgungsspannung U_{B} und die durch die unvermeidbare Fertigungsstreuung verursachte Abweichung der Stromverstärkung des zu regelnden Transistors vom Nennwert einen Weglauf des Arbeitsstromes vom gewünschten Wert hervorrufen.

Besonders bei batteriebetriebenen elektronischen Geräten sind Schwankungen der Versorgungsspannung U_{B} unvermeidbar. In Anbetracht der zunehmenden Verbreitung mobiler elektronischer Geräte wie beispielsweise das Mobiltelefon und der Laptop-Computer gewinnt der Batteriebetrieb aber immer mehr an Bedeutung. Bei der Konzipierung von elektronischen Schaltungen müssen daher Schwankungen der Versorgungsspannung U_{B} verstärkt berücksichtigt werden. Darüberhinaus sind im allgemeinen mobile elektronische Geräte großen Schwankungen der Umgebungstemperatur ausgesetzt.

Sowohl bei Schwankungen der Versorgungsspannung U_{B} als auch bei Abweichungen der Stromverstärkung B vom Nennwert gewährleistet die häufig eingesetzte Parallelgegenkopplung nur eine unzureichende Arbeitsstromstabilisierung. In beiden Fällen kommt es zu bedeutenden Änderungen des Arbeitsstromes. Die Diagramme (a) und (b) von Figur 6 belegen dies. Sie zeigen die Abhängigkeit des Arbeitsstromes von der Versorgungsspannung U_{B} bzw. von der Stromverstärkung B_{T1}.

Mit der Reihengegenkopplung läßt sich zwar eine bessere Arbeitsstromstabilisierung bei schwankender Versorgungsspannung bzw. bei Abweichung der Stromverstärkung vom Nennwert realisieren, sie besitzt jedoch den wesentlichen Nachteil, daß an dem in der Emitterzuleitung angeschlossenen Widerstand eine Spannung abfällt, die von der Versorgungsspannungsquelle zusätzlich geliefert werden muß. Hinsichtlich der bei elektronischen Geräten herrschenden Entwicklung hin zu immer niedrigeren Versorgungsspannungen ist dies aber nicht erwünscht.

Dieser Erfindung liegt daher die Aufgabe zugrunde, eine Schaltungsanordnung zu entwickeln, die bei Temperaturschwankungen, bei Abweichungen der Stromverstärkung des zu regelnden Transistors vom Nennwert und bei Schwankungen der Versorgungsspannung eine hohe Arbeitsstromstabilität des zu regelnden Transistors auch bei niedriger Versorgungsspannung gewährleistet.

Diese Aufgabe wird durch eine Schaltungsanordnung gelöst, die gekennzeichnet ist durch die Merkmale:
a) die Schaltungsanordnung weist einen zweiten Transistor, einen ersten Widerstand, eine Reihenschaltung aus mindestens einer ersten Diode und einer zweiten Diode und einen zweiten Widerstand auf,
b) die Reihenschaltung aus Dioden ist zwischen einem ersten Anschluß und der Basis des zweiten Transistors angeschlossen,
c) der Emitter des zweiten Transistors ist mit einem zweiten Anschluß verbunden,
d) der Kollektor des zweiten Transistors ist mit einem dritten Anschluß verbunden,
e) der erste Widerstand ist zwischen dem ersten Anschluß und dem zweiten Anschluß geschlossen,
f) der zweite Widerstand ist zwischen der Basis des zweiten Transistors und einem vierten Anschluß angeschlossen,
g) der erste Transistor ist mit seinem Kollektor am zweiten Anschluß, mit seiner Basis am dritten Anschluß und mit seinem Emitter am vierten Anschluß angeschlossen,
h) der vierte Anschluß ist mit einem festen Bezugspotential verbunden,
i) zwischen dem ersten und dem vierten Anschluß ist eine Versorgungsspannungsquelle angeschlossen.

Vorteilhafte Weiterbildungen dieser Schaltungsanordnung sind Gegenstand der Unteransprüche.

Neben einer hervorragenden Arbeitsstromstabilisierung hat die Schaltungsanordnung den Vorteil, daß sie in besonders kostengünstiger Art und Weise auf einem Chip integriert und in ein SMD-Gehäuse montiert werden kann.

Die Erfindung wird anhand eines Ausführungsbeispiels in Verbindung mit den Figuren 1 bis 4 näher erläutert. Es zeigen:
- Fig. 1: eine Schaltungsanordnung gemäß der Erfindung,
- Fig. 2: das Regelverhalten der erfindungsgemäßen Schaltungsanordnung bei sich ändernder Versorgungsspannung U_{B},
- Fig. 3: das Regelverhalten der erfindungsgemäßen Schaltungsanordnung bei sich ändernder Stromverstärkung B_{T1} des ersten Transistors T1,
- Fig. 4: einen Querschnitt durch eine mögliche Struktur der integrierten Schaltung der erfindungsgemäßen Schaltungsanordnung.

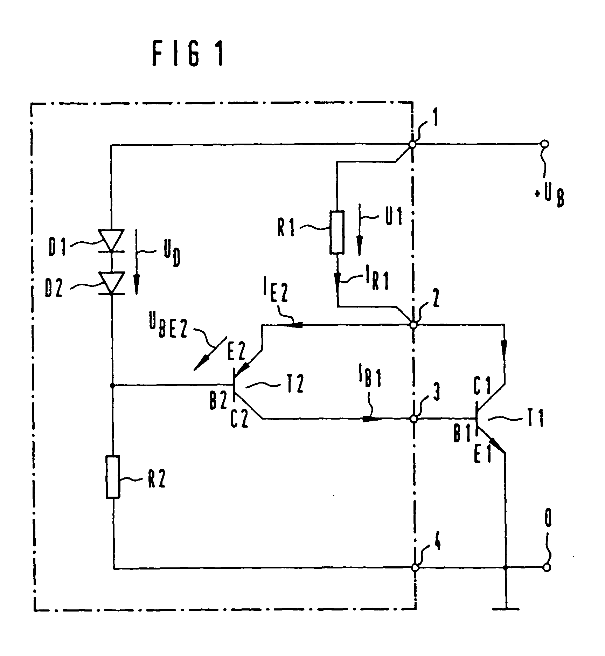

Der zu regelnde Transistor T1 in der Schaltungsanordnung nach Figur 1 ist ein npn-Transistor. Der Emitter des Transistors T1 liegt auf einem festen Potential, z.B. an Masse, und ist mit einem Anschluß 4 verbunden. Die Basis B1 des Transistors T1 ist mit einem Anschluß 3 und der Kollektor C1 des Transistors T1 ist mit einem Anschluß 2 verbunden. Ein Transistor T2, ein pnp-Transistor, ist mit seinem Kollektor C2 am Anschluß 3 und mit seinem Emitter E2 am Anschluß 2 angeschlossen. Ein Widerstand R1 ist zwischen einem Anschluß 1 und dem Emitter E2 des Transistors T2 angeschlossen. Eine Reihenschaltung aus einer Diode D1 und einer Diode D2 ist zwischen der Basis B2 des Transistors T2 und dem Anschluß 1 angeschlossen. Ein Widerstand R2 ist zwischen der Basis B2 des Transistors T2 und dem Anschluß 4 angeschlossen. Die Schaltungsanordnung ist über den Anschluß 1 und den Anschluß 4 an einer Versorgungsspannung U_{B}, beispielsweise eine Batteriespannung, angeschlossen.

Die besonders vorteilhafte Wirkungsweise dieser Schaltungsanordnung beruht auf der strombestimmenden Masche, bestehend aus der Reihenschaltung der beiden Dioden D1 und D2, dem Widerstand R1 und der Emitter-Basis-Strecke des Transistors T2. An der Reihenschaltung der Dioden D1 und D2 liegt nämlich unabhängig von der Höhe der Betriebsspannung U_{B} und unabhängig von der Stromverstärkung B_{T1} des Transistors T1 eine nahezu konstante Spannung U_{D} von etwa 1.3 V an. Ebenso liegt an der Emitter-Basis-Strecke des Transistors T2 eine nahezu gleichbleibende Spannung U_{BE2} von etwa 0.65 V an. Damit ist die Spannung U1 am Widerstand R1 mit etwa 0.65 V und folglich auch der Strom I_{R1} durch den Widerstand R1 mit I_{R1} ≈ 0.65 V/R1 festgelegt.

Der Strom I_{R1} ist die Summe aus dem zu stabilisierenden Arbeitsstrom I_{C1} des Transistors T1 und dem Emitterstrom I_{E2} des Transistors T2. Bei einer Stromverstärkung B_{T1} des Transistors T1, die größer als 40 ist, ist der Basisstrom I_{B1} des Transistors T1 und damit auch der Emitterstrom I_{E2} des Transistors T2 vernachlässigbar klein gegenüber dem Arbeitsstrom I_{C1} des Transistors T1. Somit gilt: I_{C1} ≈ 0,65 V/R1

Im Falle einer Änderung der Versorgungsspannung U_{B} bleibt die Spannung U_{D} an der Reihenschaltung der Dioden D1 und D2 aufgrund der exponentiellen Diodenkennlinie annähernd konstant. Aus dem gleichen Grund bleibt auch die Basis-Emitterspannung U_{BE2} des Transistors T2 annähernd konstant. Somit ändert sich auch die Spannung U1 am Widerstand R1 kaum, so daß auch der Arbeitsstrom I_{C1} des Transistors T1 annähernd konstant bleibt.

Auch im Falle einer fertigungsbedingten Abweichung der Stromverstärkung B_{T1} des Transistors T1 vom Nennwert bleibt der Arbeitsstrom I_{C1} des Transistors T1 nahezu unverändert. Kleinere oder größere Stromverstärkungen B_{T1} ändern den Emitterstrom I_{E2} des Transistors T2 und damit auch den Basisstrom I_{B1} des Transistors T1 derart, daß in beiden Fällen eine Gegensteuerung erfolgt. Ist beispielsweise die tatsächliche Stromverstärkung B_{T1} des Transistors T1 größer als der Nennwert, erhöht sich der Arbeitsstrom I_{C1} des Transistors T1 bei gleichzeitiger Verringerung des Emitterstromes I_{E2}, da der Strom I_{R1} durch den Widerstand R1 konstant bleibt. Die sich daraus ergebende Verringerung des Basisstromes I_{B1} des Transistors T1 bewirkt eine Senkung des Arbeitsstromes I_{C1}.

Bei Temperaturschwankungen ändert sich zum einen die Stromverstärkung B_{T1} des Transistors T1. Zum anderen ändern sich die Spannungen U_{D} und U_{BE2} um einige mV. Dies ist die Folge von Spannungsänderungen an den pn-Übergängen der Reihenschaltung der beiden Dioden D1 und D2 und der Emitter-Basis-Strecke des Transistors T2. Eine Veränderung der Stromverstärkung B_{T1} des Transistors T1 bleibt jedoch aus den oben genannten Gründen nahezu folgenlos. Der Effekt der Spannungsänderung an den pn-Übergängen wird für eine der Dioden D1 und D2 durch den pn-Übergang der Emitter-Basis-Strecke des Transistors T2 kompensiert. Übrig bleibt die Spannungsänderung einer Diode, die jedoch durch eine geeignete Temperaturcharakteristik des Widerstandes R1 kompensiert wird. Der Temperatureinfluß auf die verbleibenden Bauelemente der Schaltungsanordnung ist unbedeutend, da dadurch die strombestimmende Masche aus den beiden Dioden D1 und D2, dem Widerstand R1 und der Emitter-Basis-Strecke des Transistors T2 nicht beeinflußt wird.

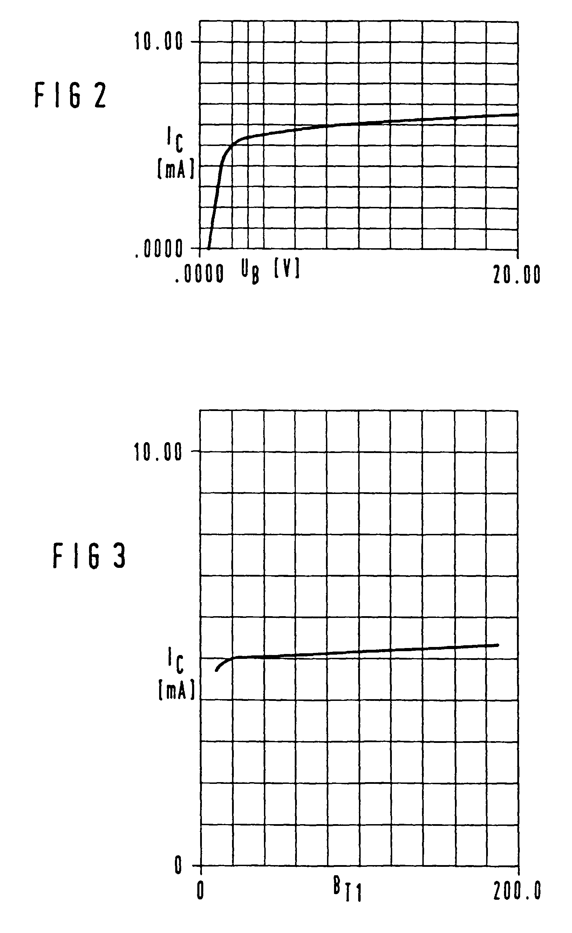

Zur Veranschaulichung des oben beschriebenen Regelverhaltens der Schaltungsanordnung nach Figur 1 ist in den Figuren 2 und 3 das Regelverhalten der Schaltungsanordnung bei sich ändernder Versorgungsspannung U_{B} bzw. bei sich ändernder Stromverstärkung B_{T1} des Transistors T1 grafisch dargestellt. Figur 2 zeigt den Arbeitsstrom I_{C1} in Abhängigkeit von der Höhe der Versorgungsspannung U_{B} und Figur 3 zeigt den Arbeitsstrom I_{C1} in Abhängigkeit von der Stromverstärkung B_{T1} des Transistors T1. Bei Vergleich mit den Diagrammen aus Figur 6 ist eine deutliche Verbesserung des Regelverhaltens gegenüber der Parallelgegenkopplung ersichtlich.

Die Schaltungsanordnung nach Figur 1 bietet die Möglichkeit, zwischen dem Anschluß 1 und dem Anschluß 2 einen zusätzlichen externen Widerstand anzuschließen. Dies erlaubt eine sehr genaue individuelle Einstellung des Arbeitsstromes I_{C1} des ersten Transistors T1

Die Schaltungsanordnung nach Figur 1 ist je nach Bedarf mit oder ohne den Widerstand R1 und mit oder ohne den Transistor T1 auf einem Chip integrierbar. Zur Integration kann eine besonders einfache und kostengünstige Technologie mit einer geringen Anzahl von Prozeßschritten eingesetzt werden. Im Falle des Weglassens des Widerstandes R1 auf der integrierten Schaltung ist zur Aufrechterhaltung der Funktion der Schaltungsanordnung zwischen dem Anschluß 1 und dem Anschluß 2 der Widerstand R1 extern anzuschließen.

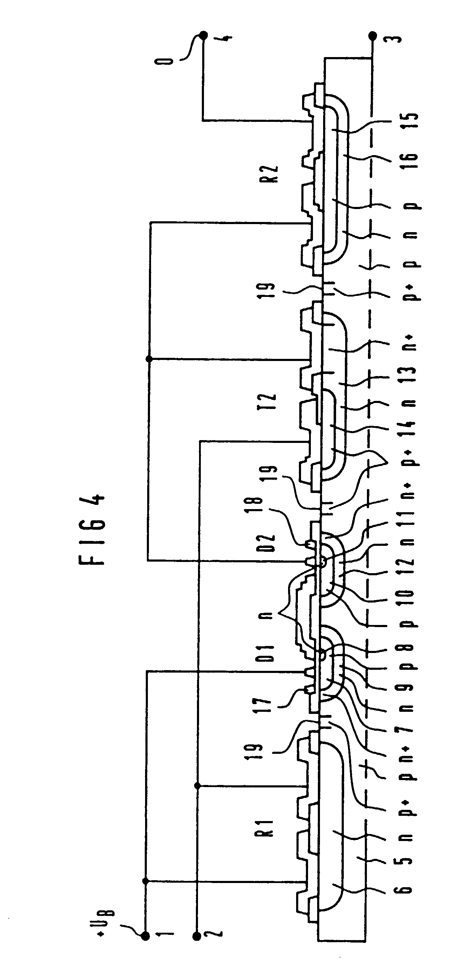

Figur 4 zeigt den schematischen Querschnitt eines Ausführungsbeispieles eines integrierten Aufbaus der Schaltungsanordnung nach Figur 1 ohne den Transistor T1. Ausgehend von einem p-leitenden Substrat sind die Bauelemente der Schaltungsanordnung in getrennten n-leitenden Wannen realisiert. Der Widerstand R1 besteht aus einer n-leitenden Wanne 6. Die Diode D1 setzt sich aus einer p-leitenden Wanne 7 und einer darin eingebetteten n-leitenden Wanne 8 zusammen und ist in eine n-leitende Wanne 9 eingebettet. Analog dazu setzt sich die Diode D2 aus einer p-leitenden Wanne 10 und einer darin eingebetteten n-leitenden Wanne 11 zusammen und ist in eine n-leitende Wanne 12 eingettet. Der von der Wanne 7 und der Wanne 9 gebildete pn-Übergang und der von der Wanne 10 und der Wanne 12 gebildete pn-übergang ist an der Oberfläche kurzgeschlossen. Die n-leitende Wanne 13, die darin eingebettete p-leitende Wanne 14 und das p-leitende Substrat 5 bilden den Transistor T2. Die p-leitende Wanne 15, die in eine n-leitende Wanne 16 eingebettet ist, bildet den Widerstand R2. Zwischen den einzelnen Bauelementen ist ein p-leitender Schutzring 19 (Guardring) angeordnet.

Die Einbettung der Dioden D1 und D2 in jeweils einer n-leitenden Wanne bewirkt, daß sowohl bei positiver als auch bei negativer Spannung zwischen den Diodenanschlüssen und der Unterseite des Chips ein pn-Übergang in Sperrichtung gepolt ist. Aus dem gleichen Grund ist auch der Widerstand R2 in Form einer in eine n-leitende Wanne eingebetteten p-leitenden Wanne ausgebildet. Das Kurzschließen des von der Wanne 7 und der Wanne 9 gebildeten pn-Überganges und des von der Wanne 10 und der Wanne 12 gebildeten pn-Überganges verhindert ein Zünden des an jeder Diode ausgebildeten parasitären Thyristors.

Das oben beschriebene Verfahren zur Herstellung der integrierten Schaltung von Figur 4 zeichnet sich in besonders vorteilhafter Weise durch eine geringe Anzahl von Prozeßschritten aus. Der erste Widerstand R1, die n-leitende Wanne 9, die n-leitende Wanne 12, die Basis B2 (n-leitende Wanne 13) des Transistors T2 und die n-leitende Wanne 16 werden in einem Schritt strukturiert und dotiert. Ebenso werden anschließend in einem Schritt die p-leitende Wanne 7, die p-leitende Wanne 10, der Emitter E2 (p-leitende Wanne 14) des Transistors T2 und der p-leitende Guardring 19 strukturiert und dotiert.

## Patentansprüche

1. Integrierbare Schaltungsanordnung zur Arbeitspunktstabilisierung eines ersten Transistors (T1) durch Gegenkopplung, gekennzeichnet durch die Merkmale:
a) die Schaltungsanordnung weist einen zweiten Transistor (T2), einen ersten Widerstand (R1), eine Reihenschaltung aus mindestens einer ersten Diode (D1) und einer zweiten Diode (D2) und einen zweiten Widerstand (R2) auf,
b) die Reihenschaltung aus Dioden ist zwischen einem ersten Anschluß (1) und der Basis (B2) des zweiten Transistors (T2) angeschlossen,
c) der Emitter (E2) des zweiten Transistors (T2) ist mit einem zweiten Anschluß (2) verbunden,
d) der Kollektor (C2) des zweiten Transistors (T2) ist mit einem dritten Anschluß (3) verbunden,
e) der erste Widerstand (R1) ist zwischen dem ersten Anschluß (1) und dem zweiten Anschluß (2) angeschlossen,
f) der zweite Widerstand (R2) ist zwischen der Basis (B2) des zweiten Transistors (T2) und einem vierten Anschluß (4) angeschlossen,
g) der erste Transistor (T1) ist mit seinem Kollektor (C1) am zweiten Anschluß (2), mit seiner Basis (B1) am dritten Anschluß (3) und mit seinem Emitter (E1) am vierten Anschluß (4) angeschlossen,
h) der vierte Anschluß ist mit einem festen Bezugspotential verbunden,
i) zwischen dem ersten und dem vierten Anschluß (1 bzw. 4) ist eine Versorgungsspannungsquelle angeschlossen.

2. Schaltungsanordnung nach Anspruch 1, dadurch gekennzeichnet, daß der zweite Transistor (T2), die Reihenschaltung und der zweite Widerstand (R2) auf ein und demselben Chip integriert sind.

3. Schaltungsanordnung nach Anspruch 2, dadurch gekennzeichnet, daß auch der erste Widerstand (R1) auf demselben Chip integriert ist.

4. Schaltungsanordnung nach Anspruch 3, dadurch gekennzeichnet, daß auch der erste Transistor (T1) auf demselben Chip integriert ist.

5. Schaltungsanordnung nach Anspruch 3, gekennzeichnet durch die Merkmale:
a) die Schaltungsanordnung ist in einem Substrat (5) vom ersten Leitungstyp ausgebildet,
b) der erste Widerstand (R1) ist aus einer ersten Wanne (6) vom zweiten Leitungstyp gebildet,
c) die erste Diode (D1) ist aus einer zweiten Wanne (7) vom ersten Leitungstyp und einer darin eingebetteten dritten Wanne (8) vom zweiten Leitungstyp gebildet und in eine vierte Wanne (9) vom zweiten Leitungstyp eingebettet,
d) die zweite Diode (D2) ist aus einer fünften Wanne (10) vom ersten Leitungstyp und einer darin eingebetteten sechsten Wanne (11) vom zweiten Leitungstyp gebildet und in eine siebte Wanne (12) vom zweiten Leitungstyp eingebettet,
e) der zweite Transistor (T2) setzt sich aus einer achten Wanne (13) vom zweiten Leitungstyp, einer in die achte Wanne (13) eingebetteten neunten Wanne (14) vom ersten Leitungstyp und dem Substrat (5) zusammen,
f) der zweite Widerstand (R2) ist aus einer zehnten Wanne (15) vom ersten Leitungstyp gebildet und in eine elfte Wanne (16) vom zweiten Leitungstyp eingebettet, und
g) der von der zweiten (7) und der vierten Wanne (9) gebildete pn-Übergang und der von der fünften (10) und der siebten Wanne (12) gebildete pn-Übergang ist an der Oberfläche kurzgeschlossen.

## Claims

1. Integrable circuit arrangement for stabilizing the operating point of a first transistor (T1) by negative feedback, characterized by the following features:
a) the circuit arrangement has a second transistor (T2), a first resistor (R1), a series circuit formed by at least one first diode (D1) and one second diode (D2), and a second resistor (R2),
b) the series circuit formed by diodes is connected between a first terminal (1) and the base (B2) of the second transistor (T2),
c) the emitter (E2) of the second transistor (T2) is connected to a second terminal (2),
d) the collector (C2) of the second transistor (T2) is connected to a third terminal (3),
e) the first resistor (R1) is connected between the first terminal (1) and the second terminal (2),
f) the second resistor (R2) is connected between the base (B2) of the second transistor (T2) and a fourth terminal (4),
g) the first transistor (T1) is connected to the second terminal (2) by its collector (C1), to the third terminal (3) by its base (B1) and to the fourth terminal (4) by its emitter (E1),
h) the fourth terminal is connected to a fixed reference-earth potential,
i) a supply voltage source is connected between the first and fourth terminals (1 and 4 respectively).

2. Circuit arrangement according to Claim 1, characterized in that the second transistor (T2), the series circuit and the second resistor (R2) are integrated on one and the same chip.

3. Circuit arrangement according to Claim 2, characterized in that the first resistor (R1) is also integrated on the same chip.

4. Circuit arrangement according to Claim 3, characterized in that the first transistor (T1) is also integrated on the same chip.

5. Circuit arrangement according to Claim 3, characterized by the following features:
a) the circuit arrangement is constructed in a substrate (5) of the first conduction type,
b) the first resistor (R1) is formed from a first well (6) of the second conduction type,
c) the first diode (D1) is formed from a second well (7) of the first conduction type and a third well (8) of the second conduction type, the said third well being embedded in the said second well, and is embedded in a fourth well (9) of the second conduction type,
d) the second diode (D2) is formed from a fifth well (10) of the first conduction type and a sixth well (11) of the second conduction type, the said sixth well being embedded in the said fifth well, and is embedded in a seventh well (12) of the second conduction type,
e) the second transistor (T2) is composed of an eighth well (13) of the second conduction type, a ninth well (14) of the first conduction type, the said ninth well being embedded in the eighth well (13), and the substrate (5),
f) the second resistor (R2) is formed from a tenth well (15) of the first conduction type and is embedded in an eleventh well (16) of the second conduction type, and
g) the pn-junction formed by the second (7) and the fourth well (9) and the pn-junction formed by the fifth (10) and the seventh well (12) are shortcircuited at the surface.

## Revendications

1. Circuit intégrable pour stabiliser par contre-réaction le courant de travail d'un premier transistor (T1), caractérisé par les particularités suivantes:
a) le circuit comporte un deuxième transistor (T2), une première résistance (R1), un circuit série comprenant au moins une première diode (D1) et une deuxième diode (D2) et une deuxième résistance (R2),
b) le circuit série des diodes est raccordé entre un premier point de connexion (1) et la base (B2) du deuxième transistor (T2),
c) l'émetteur (E2) du deuxième transistor (T2) est relié à un deuxième point de connexion (2),
d) le collecteur (C2) du deuxième transistor (T2) est relié à un troisième point de connexion (3),
e) la première résistance (R1) est branchée entre le premier point de connexion (1) et le deuxième point de connexion (2),
f) la deuxième résistance (R2) est raccordée entre la base (B2) du deuxième transistor (T2) et un quatrième point de connexion (4),
g) le premier transistor (T1) est raccordé par son collecteur (C1) au deuxième point de connexion (2), par sa base (B1) au troisième point de connexion (3) et par son émetteur (E1) au quatrième point de connexion (4),
h) le quatrième point de connexion est relié à un potentiel de référence fixe,
i) une source de tension d'alimentation est branchée entre le premier et le quatrième point de connexion (1 et 4).

2. Circuit selon la revendication 1 caractérisé par le fait que le deuxième transistor (T2), le circuit série et la deuxième résistance (R2) sont intégrés sur une seule et même puce.

3. Circuit selon la revendication 2 caractérisé par le fait que la première résistance (R1) est aussi intégrée sur la même puce.

4. Circuit selon la revendication 3 caractérisé par le fait que le premier transistor (T1) est aussi intégré sur la même puce.

5. Circuit selon la revendication 3 caractérisé par les particularités suivantes:
a) le circuit est formé dans un substrat (5) du premier type de conductivité,
b) la première résistance (R1) est formée par une première cuvette (6) du deuxième type de conductivité,
c) la première diode (D1) est formée par une deuxième cuvette (7) du premier type de conductivité et par une troisième cuvette (8) du deuxième type de conductivité, laquelle est encastrée dans la deuxième cuvette (7), et encastrée dans une quatrième cuvette (9) du deuxième type de conductivité,
d) la deuxième diode (D2) est formée par une cinquième cuvette (10) du premier type de conductivité et par une sixième cuvette (11) du deuxième type de conductivité, laquelle est encastrée dans la cinquième cuvette (10), et encastrée dans une septième cuvette (12) du deuxième type de conductivité,
e) le deuxième transistor (T2) est composé d'une huitième cuvette (13) du deuxième type de conductivité, d'une neuvième cuvette (14), du premier type de conductivité, encastrée dans la huitième cuvette (13) et du substrat (5),
f) la deuxième résistance (R2) est formée par une dixième cuvette (15) du premier type de conductivité et est encastrée dans une onzième cuvette (16) du deuxième type de conductivité et
g) la jonction pn formée par la deuxième (7) et la quatrième (9) cuvette et la jonction pn formée par la cinquième (10) et la septième (12) cuvette sont court-circuitées en surface.
